# EUROPEAN PATENT SPECIFICATION

(11) **EP 2 169 829 B1**
(45) Date of publication and mention of the grant of the patent: **04.01.2012**
(21) Application number: 08016777.8
(22) Date of filing: 24.09.2008
(51) Int. Cl.: H03M 1/06, H03M 1/46, H03M 1/68

(54) **Analog-to-digital converter and method for analog-to-digital conversion**
Analog-Digital-Umsetzer und Verfahren zur Analog-Digital-Umsetzung
Convertisseur analogique-numérique et procédé de conversion analogique-numérique

(43) Date of publication of application: 31.03.2010
(73) Proprietor: Austriamicrosystems AG, 8141 Unterpremstätten (AT)
(72) Inventor: Vinau, Jose, 46007 Valencia (ES)
(74) Representative: Epping - Hermann - Fischer

(56) References cited:
- US-A- 5 006 854
- US-B1- 7 199 746

## Description

The invention relates to an analog-to-digital converter and to a method for analog-to-digital conversion, each working according to a successive approximation principle.

Analog-to-digital converters, abbreviated AD converters, are widely used for connecting analog circuitry to digital circuitry. A successive approximation register principle is common for AD converters.

To achieve a high accuracy for AD converters, in some cases trimming algorithms are implemented to compensate for mismatches in critical elements in the circuit. However, a respective trimming circuitry can increase the area of a final die in an integrated circuit. Additionally, a design time can possibly be increased, for example because of testing of the trimming algorithm. Therefore, in conventional AD converters, measures for increasing the accuracy usually are complex and expensive.

US 7,199,746 B shows a method for selecting capacitors from a capacitor array for each bit of a SAR ADC. The process involves selecting a group of capacitors from the capacitor array and determining a weight of the selected group of capacitors. A determination is made if the weights of the selected group of capacitors are substantially equal to their desired values. If the weights are substantially equal to their desired values, the selected group of capacitors is associated with each bit of the SAR ADC. If the weights are not substantially equal to their desired values, a next group of capacitors from the capacitor array is selected for the bits. This process of selecting a group of capacitors and determining their weights is repeated until determined weight for a group of capacitors equals or is closest to the desired values.

US 5,006,854 A shows a method and apparatus for removing the effects of mismatched components in an ADC. In particular, an array of equally-sized capacitors is coupled to a switching network. A successive approximation scheme is implemented in which the input signal is coupled through SAR switches to the capacitor array. Each switch is coupled to 2N-1 capacitors where N is the switch number. For example, in an 8-bit scheme, there are 3 switches with switch 1 coupled to one capacitor, switch 2 coupled to two capacitors, and switch 3 coupled to four capacitors. In this manner, eight levels of capacitance values can be defined. A scramble control code is added to control the switching array so that the physical capacitors themselves are coupled to different SAR switches at different times. This requires a scramble matrix of switches, which requires Nx2N switches where N equals the number of bits of control code. In this manner, the effects of variations in the capacitance ratios is averaged out and converted to noise which can be filtered out of the signal.

It is an object of the present invention to provide an analog-to-digital converter and a method for analog-to-digital conversion which provide an improved accuracy with reduced complexity and effort.

The object is achieved with the subject matter of the independent patent claims. Embodiments and developments of the invention are subject matter of the dependent claims.

According to one embodiment, an analog-to-digital converter comprises a digital-to-analog converter, abbreviated DA converter, with a first array of charge stores being switchable depending on a first control signal and a second array of charge stores being switchable depending on a second control signal. Charge stores of a subset of the charge stores of the second array have basically equal values. Hereby, the DA converter is configured to generate an output voltage as a function of a switching state of the charge stores of the first and the second array. The analog-to-digital converter further comprises comparison means for comparing the output voltage with an input voltage and a control register comprising a data output for providing a digital value corresponding to the input voltage as a function of a comparison result of the comparison means. The control register is configured to generate the first control signal and an intermediate control signal according to a successive approximation principle as a function of the comparison result. A switching selector of the analog-to-digital converter is configured to generate a second control signal as a function of the intermediate control signal such that segments having binary weighted values are formed with the charge stores of the subset of charge stores in an arbitrary manner.

The analog-to-digital converter basically works according to a successive approximation principle. Accordingly, during operation of the analog-to-digital converter, the control register tries to find the best match between an output voltage generated by the DA converter with the input voltage to be converted to a digital signal. The approximation process is performed in several steps until the digital value corresponding to the input voltage is found. During the approximation process, the control register controls the DA converter by means of the first and the second or intermediate control signal, respectively, for generating a specific output voltage.

In the DA converter, the conversion is based on a switching state of the first array and a second array of charge stores. For example, the first array comprises binary weighted charge stores like capacitors representing lower significance bits of the digital value. The second array of charge stores comprises at least a subset of charge stores having basically equal values, wherein the term "equal" is limited by production tolerances. The second array represents higher significance bits of the digital value.

In conventional DA converters, each of the charge stores is dedicated to a specific bit of the digital value in a fixed and predetermined manner. For example, the equal weighted charge stores of the subset are conventionally controlled in a thermometer coded manner during the approximation process, wherein the respective charge stores are switched on or off in a predetermined order.

In the embodiment of the analog-to-digital converter described above, the control register, which can be a successive approximation register, generates the first control signal for controlling the first array of charge stores and the intermediate control signal which is provided to the switching selector. The first control signal and the intermediate control signal taken together correspond to a digital value which should serve as a basis for generating the output voltage of the DA converter. In the switching selector, the second control signal is generated from the intermediate control signal such that arbitrary combinations of charge stores of the subset are formed, wherein each of the combinations corresponds to the same nominal value to be represented by the second array of charge stores. Therefore, it is possible to generate several output voltages based on the same digital value, wherein the output voltages in an ideal case would have the same value but in real life usually slightly differ. Based on the several output voltages, mismatches of the charge stores can be eliminated, which improves the accuracy of the analog-to-digital converter.

In some embodiments, the charge stores of the first array of charge stores can also have values deviating from a binary weighting. In this case, deviations in the generated output voltage can be calculated out by the control register, for example.

To this end, in one embodiment, filtering means can be comprised by the analog-to-digital converter which processes the digital value. For example, the filtering means comprise an averaging filter which filters out small disturbances of the digital value caused by slightly varying output voltages based on the arbitrarily formed segments of the charge stores of the subset. Therefore, the accuracy of the analog-to-digital converter can be further increased.

In some embodiments, the comparison means are comprised by the DA converter. For example, during generating of the output voltage in the DA converter, a charge or a voltage, respectively, generated with the charge stores of the first and the second array are directly combined with the input voltage such that a resulting output directly indicates whether the generated output voltage is greater or less than the input voltage.

In one embodiment, the switching selector comprises a random generator or a look-up table or a shift register for providing a plurality of different combinations for forming the segments in the arbitrary manner. For example, the random generator generates a pseudo-random sequence of combinations for switching on and off the charge stores of the subset to form respective segments. In other words, the random generator is embodied as a pseudo random generator. In the look-up table, a set of segment combinations can be stored for each possible value of the digital intermediate control signal which will be provided to the second array of charge stores in a predetermined or arbitrary manner. It should be noted that even if the combinations stored in the look-up table are provided to the second array in a predetermined sequence, the arbitrary forming of segments is given by the selection of combinations stored arbitrarily in the look-up table. In the shift register, a digital word corresponding to charge stores to be activated can be shifted in each step of the sequence. Also in this case the segments are formed in an arbitrary manner.

In one embodiment, the subset comprises all charge stores of the second array. In other words, the bits of the digital value corresponding to the second control signal or the intermediate control signal, respectively, are depending on the number of charge stores switched on or off, respectively.

In another embodiment, the second array comprises the subset and one charge store or at least two charge stores being binary weighted. Herein, the equal values of the subset are basically twice the value of the one charge store or of the largest value of the at least two charge stores. In other words, a binary value of the second array depends on the respective values of the one or at least two charge stores and the binary weighted segments formed by the charge stores of the subset.

In another embodiment, the second array comprises the subset and one ore more charge stores whose capacitance values can be independent from the equal values of the subset. Also in this case, deviations in the generated output voltage can be calculated out by the control register, for example.

Preferably, the segments formed by the subset correspond to the most significant bits of the digital value.

An embodiment of a method for analog-to-digital conversion is performed with a DA converter having a first array of charge stores being switchable depending on a first control signal, a second array of charge stores being switchable depending on a second control signal, wherein charge stores of a subset of the charge stores of the second array (MC) have basically equal values. The method is performed iteratively and comprises generating an output voltage as a function of a switching state of the charge stores of the first and the second array. The output voltage is compared with an input voltage. A first control signal and an intermediate control signal are generated according to a successive approximation principle as a function of the comparison result. The second control signal is generated as a function of the intermediate control signal such that segments having binary weighted values are formed with the charge stores of the subset of charge stores in an arbitrary manner for different iterations. Based on the comparison result, a digital value corresponding to the input voltage is provided.

As for different iterations of the approximation process, respective different segments of the charge stores of the subset are used to form respective binary weighted values, possible mismatches of the equal weighted charge stores can be eliminated over a sequence of iterations. Therefore, the accuracy of the conversion process can be improved.

To this end, in some embodiments, a stream of iteratively provided digital values can be filtered. The filtering is preferably carried out to average out deviations in the digital values caused by a mismatch of the values of the basically equal weighted charge stores of the subset.

The text below explains the invention in detail using exemplary embodiments with reference to the drawings, in which:
- FIG. 1: is an embodiment of an analog-to-digital converter, and
- FIG. 2: is an embodiment of an array of charge stores to be used in the analog-to-digital converter of FIG. 1.

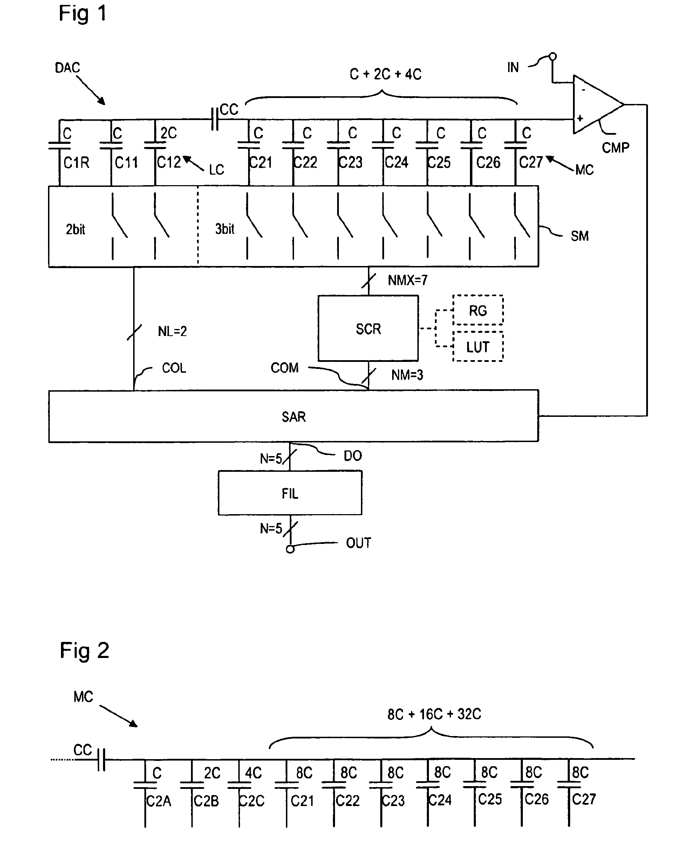

FIG. 1 shows an embodiment of an analog-to-digital converter comprising a DA converter DAC, comparison means CMP, a control register SAR and a switching selector SCR. The DA converter DAC comprises a first array LC of charge stores C1R, C11, C12 and a second array MC of charge stores C21 to C27. The DA converter DAC further comprises switching means SM having respective switches for controlling a switching state of the charge stores of the first and the second array LC, MC. The first and the second array LC, MC are coupled by a coupling capacitor CC. An output of the DA converter DAC is coupled to a non-inverting input + of the comparison means CMP, while an inverting input - of the comparison means CMP is coupled to a signal input IN. An output of the comparison means CMP is coupled to the control register SAR.

A first control output COL of the control register SAR is coupled to a part of the switching means SM corresponding to the first array LC. A second control output COM is coupled to the switching selector SCR whose output is coupled to a part of the switching means SM corresponding to the second array MC. A data output DO of the control register SAR is coupled to an output connection OUT by filtering means FIL. In various embodiments, the switching selector SCR can be coupled to a random generator RG and/or a look-up table LUT which are shown with dashed lines as being optional components of the analog-to-digital converter.

The charge stores of the first and the second array LC, MC are shown as capacitors whereas other implementations for the charge stores like varactors etc. are possible and well-known in the art. The first array LC comprises a reference capacitor C1R having a reference value C. It should be noted that the values shown above the charge stores of the first and the second array LC, MC denote a relative value in relation to the value C of the reference capacitor C1R. Accordingly, the first and the second charge store C11, C12 of the first array LC have binary weighted values of C and 2C, respectively, corresponding to the two least significant bits used for representing an analog input voltage at the input connection IN as a digital value. A switching state of the charge stores C11, C12 is determined by a first control signal provided at the first control output COL and, for example, being a control word with a word length of NL = 2

The control register SAR further provides an intermediate control signal at the second control output COM. In this embodiment, the intermediate control signal is a control word having a word length of NM = 3 corresponding to three most significant bits of the digital value to be represented by the DA converter DAC. The intermediate control signal indicates that a specific number of charge stores of the second array MC should be activated while, for example, the rest of the charge stores of the second array MC are deactivated by a respective switching state. The switching selector SCR generates respective switching signals by means of the second control signal.

For example, in this embodiment, a control word having a word length of NMX = 7 for controlling the seven switches in the switching means is provided by the switching selector SCR. However, if, for example, three charge stores of the second array MC have to be activated, the switching selector SCR does not necessarily switch on the first three charge stores C21, C22, C23 like it would be in a conventional DA converter DAC but arbitrarily or randomly selects any three charge stores out of the subset of seven charge stores C21 to C27 of the second array MC. The information which of the charge stores are to be switched on in each case can be provided by the random generator RG or the look-up table LUT which provides arbitrary combinations of respective charge stores to be activated or deactivated, respectively. However, the information can also be provided internally within the switching selector SCR in a different way, for example by a shift register holding a data word corresponding to the charges stores to be activated. In this case, said data word is shifted for each iteration.

The DA converter DAC generates a respective output voltage as a function of the switching states of the charge stores of the first and the second array LC, MC, wherein the output voltage is compared with an input voltage provided at the input connection IN, wherein the comparison result is provided to the control register SAR. The voltage generation step and the comparison step are performed iteratively. For example, in a next iteration step or approximation step for the intermediate control signal being, for example, identical to the previous one, the switching selector SCR generates the second control signal such that the combination of charge stores being activated or deactivated is different from the previous combination. For example, a predetermined number of voltage generation steps and comparison steps can be performed with the intermediate control signal being equal but the second control signal for each of the steps being different or, in other words, representing different combinations of activated and deactivated charge stores. The predetermined number of combinations can be received from the random generator RG or from the look-up table LUT.

In this embodiment, the switching selector SCR is able to form binary weighted segments of charge stores which in this example have a value of C, 2C and 4C, respectively. Accordingly, with the seven charge stores C21 to C27, a total value of C+2C+4C can be formed. None of the charge stores C21 to C27 is dedicated to a specific segment but can be assigned to any of the three segments to be formed. For example, a segment having the value 2C can be formed by the charge stores C21 and C22 in one iteration step and can be formed by the charge stores C23 and C24 in a next iteration step. If the charge stores, which have basically the same value but slightly differ because of production tolerances or mismatches, are used in the two above-mentioned iteration steps, a different comparison result can occur for the output voltage generated by the two differently formed segments. However, the comparison results which determine the digital value corresponding to the input voltage and therefore can produce different digital values, can be averaged out or filtered out by the filtering means FIL. In other words, for each of the iteration steps, a respective digital value can be provided at the data output DO which in this case has a word length of N = 5, thus forming a stream of digital values.

That stream of digital values can be filtered by the filtering means FIL, preferably by an averaging filter which can be a digital FIR or an IIR filter. Therefore, variances in the digital values caused by possible mismatches of the charge stores can be filtered out or averaged out. As a consequence, the influence of mismatches of the charge stores of the second array MC can be reduced. This can, for example, be especially useful for the segments corresponding to most significant bits of the digital value because the accuracy of the most significant bits in the DA converter is able to determine the overall accuracy of the analog-to-digital conversion arrangement.

In the embodiment shown in FIG. 1, the charge stores C21 to C27 each have basically the same value C and can all be used for forming the three binary weighted segments, wherein each segment corresponds to one bit of the digital value. In other words, the second array MC comprises a set or a subset of charge stores which comprises all of the charge stores C21 to C27 of the second array MC.

In another embodiment, the values of the charge stores of the first array LC can be different from the values shown in FIG. 1, especially regarding the binary relationship between the first and the second array LC, MC. In this case, deviations in the generated output voltage can be calculated out by the control register SAR, for example.

FIG. 2 shows an alternative embodiment of a second array MC of charge stores comprising three binary weighted charge stores C2A, C2B, C2C having values of C, 2C and 4C, respectively. The second array MC further comprises a subset of charge stores C21 to C27 each having basically the same value of 8C. In other words, the equal values of the charge stores C21 to C27 of the subset are basically twice the value of the largest value of the remaining charge stores C2A, C2B, C2C which in this case is 4C of the charge store C2C.

Similarly to the embodiment described above for FIG. 1, the seven charge stores C21 to C27 can be used to form binary weighted segments corresponding to values 8C, 16C and 32C respectively. Accordingly, the largest value to be represented by the three segments can be 8C+16C+32C.

The second array MC shown in FIG. 2 corresponds to 6 Bit to be represented within the digital value, wherein the three most significant bits of the digital value can be represented by the respective segments to be formed. With reference to FIG. 1, the intermediate control signal provided by the control register SAR would have a word length of NM = 6 in this case. Accordingly, the switching selector SCR provides the second control signal with a word length of NMX = 10 from which 3 bits are used to control a switching state of the charge stores C2A, C2B, C2C and 7 bits are used to control a switching state of the charge stores C21 to C27 to form respective segments. In other words, 3 bits of the intermediate control signal remain unchanged while the remaining three more significant bits are used to arbitrarily form the binary weighted segments. As described before for FIG. 1, different combinations of the charge stores C21 to C27 can be used to form the respective segments in an arbitrary manner, controlled by the switching selector SCR.

In an embodiment similar to the embodiment of FIG. 2, the charge stores C2A, C2B, C2C have values being different from C, 2C and 4C, respectively. In particular, it is possible to implement the second array MC with charge stores C2A, C2B, C2C having values not being binary weighted. Furthermore, the charge stores C21 to C27 can have an equal value not being dependent on the largest value of the remaining charge stores C2A, C2B, C2C. In these cases, deviations in the generated output voltage can be calculated out by the control register SAR, for example.

It should be noted that the number of charge stores and any word lengths of the control signals of the embodiments presented are not limited to the specific numbers or values shown in the embodiments of FIGS. 1 and 2. Accordingly, it is also possible that the second array MC comprises, for example, a single charge store C2A having a value of C and a subset of charge stores for forming a specific number of segments, wherein the charge stores of the subset basically could have an equal value of 2C. Furthermore, the number of charge stores comprised by the subset is not limited to seven charge stores representing 3 bits but could also be 15 charge stores for representing 4 bits, 31 charge stores for representing 5 bits and so on.

Furthermore, the number of charge stores comprised by the first array LC can be different and should only be limited by the ability to form binary weighted values for representing the least significant bit of the digital value.

By the arbitrary forming of the segments with the equal weighted charge stores of the subset in the second array MC, the linearity in conversion can be improved, as possible mismatches in the charge stores of the subset can be eliminated. Furthermore, the use of the filtering means FIL can lead to an improved signal-to-noise ratio SNR. As more comparisons could have to be performed for an input voltage compared to a conventional analog-to-digital converter, the sampling rate may be reduced. However, with respect to basically increasing sampling rates in the art, the sampling rate is usually not a limiting factor for such applications. In consequence, based on the above described embodiments, an AD converter with improved linearity and improved SNR can be provided.

It should be further noted that a switching selector SCR can select pseudo-randomly the charge stores for each bit trial. For example, when new segments need to be activated, these can be selected pseudo-randomly. Accordingly, when segments have to be disconnected, the disconnection from existing active segments can be performed pseudo-randomly, therefore holding the benefit of a segmented architecture.

The effect of the pseudo-random selection of segments to be active can have the effect that each DA conversion could lead to a different digital value regardless of being the analog input constant. If a number of conversions are run with the same analog input and averaged with filtering means FIL, which can have a low pass behavior, any imperfections of the charge stores of the subset can be cancelled out, which can lead to an increase in the accuracy of the AD converter. The filtering means can be configured such in various embodiments that possible noise generated by the switching selector SCR can be cancelled out. For example an averaging ratio can be set such that it equals the number of combinations used for representing a single digital value. In any case, filtering of the stream of digital values can reduce possible noise generated by the switching selector SCR.

### Reference list

- DAC: digital-to-analog converter
- LC, MC: charge store array
- CMP: comparison means
- SM: switching means
- SCR: switching selector
- SAR: control register
- FIL: filtering means
- RG: random generator
- LUT: look-up table
- IN: input connection
- DO: data output
- OUT: output connection
- C1R, C11, C12: charge store
- C21 to C27: charge store
- C2A, C2B, C2C: charge store
- CC: coupling charge store
- COL, COM: control output

## Claims

1. Analog-to-digital converter, comprising
- a digital-to-analog converter (DAC) having a first array (LC) of charge stores (C1R, C11, C12) being switchable depending on a first control signal, a second array (MC) of charge stores (C21, C22, ...) being switchable depending on a second control signal, wherein charge stores of a subset of the charge stores of the second array (MC) have basically equal values and the digital-to-analog converter (DAC) is configured to generate an output voltage as a function of a switching state of the charge stores (C1R, C11, C12, ..., C21, C22, ...) of the first and the second array (LC, MC);
- comparison means (CMP) for comparing the output voltage with an input voltage;
- a control register (SAR) comprising a data output (DO) for providing a digital value corresponding to the input voltage as a function of a comparison result of the comparison means (CMP), the control register (SAR) being configured to generate the first control signal and an intermediate control signal according to a successive approximation principle as a function of the comparison result; and
- a switching selector (SCR) being configured to generate the second control signal as a function of the intermediate control signal such that segments having binary weighted values are formed with the charge stores of the subset of charge stores in an arbitrary manner and such that arbitrary combinations of charge stores of the subset are formed, wherein each of the combinations corresponds to the same nominal value to be represented by the second array of charge stores.

2. Analog-to-digital converter according to claim 1, further comprising filtering means (FIL) for processing the digital value.

3. Analog-to-digital converter according to claim 2, wherein the filtering means (FIL) comprise an averaging filter.

4. Analog-to-digital converter according to one of claims 1 to 3, wherein the comparison means (CMP) are comprised by the digital-to-analog converter (DAC).

5. Analog-to-digital converter according to one of claims 1 to 4, wherein the first control signal corresponds to lower significance bits of the digital value, and the second control signal and the intermediate control signal correspond to higher significance bits of the digital value.

6. Analog-to-digital converter according to one of claims 1 to 5, wherein the switching selector (SCR) comprises a random generator (RG) or a lookup-table (LUT) or a shift register for providing a plurality of different combinations for forming the segments in the arbitrary manner.

7. Analog-to-digital converter according to one of claims 1 to 6, wherein the subset comprises all charge stores of the second array (MC).

8. Analog-to-digital converter according to one of claims 1 to 6, wherein the second array (MC) comprises the subset and one charge store or at least two charge stores being binary weighted, and wherein the equal values of the subset are basically twice the value of the one charge store or of the largest value of the at least two charge stores.

9. Method for analog-to-digital conversion with a digital-to-analog converter (DAC) having a first array (LC) of charge stores (C1R, C11, C12) being switchable depending on a first control signal, a second array (MC) of charge stores (C21, C22, ...) being switchable depending on a second control signal, wherein charge stores of a subset of the charge stores of the second array (MC) have basically equal values, the method performed iteratively and comprising
- generating an output voltage as a function of a switching state of the charge stores (C1R, C11, C12, ..., C21, C22, ...) of the first and the second array (LC, MC);
- comparing the output voltage with an input voltage;
- generating the first control signal and an intermediate control signal according to a successive approximation principle as a function of the comparison result;
- generating the second control signal as a function of the intermediate control signal such that segments having binary weighted values are formed with the charge stores of the subset of charge stores in an arbitrary manner for different iterations and such that arbitrary combinations of charge stores of the subset are formed, wherein each of the combinations corresponds to the same nominal value to be represented by the second array of charge stores; and
- providing a digital value corresponding to the input voltage as a function of the comparison result.

10. Method according to claim 9, wherein a stream of iteratively provided digital values is filtered.

11. Method according to claim 9 or 10, wherein the first control signal corresponds to lower significance bits of the digital value, and the second control signal and the intermediate control signal correspond to higher significance bits of the digital value.

12. Method according to one of claims 9 to 11, wherein a plurality of different combinations are provided by a random generator (RG) or by a lookup-table (LUT) or by a shift register for forming the segments in the arbitrary manner.

13. Method according to one of claims 9 to 12, wherein the subset comprises all charge stores of the second array (MC).

14. Method according to one of claims 9 to 12, wherein the second array (MC) comprises the subset and one charge store or at least two charge stores being binary weighted, and wherein the equal values of the subset are basically twice the value of the one charge store or of the largest value of the at least two charge stores.

## Patentansprüche

1. Analog/Digital-Wandler, Folgendes umfassend:
- einen Digital/Analog-Wandler (DAC) mit einer ersten Anordnung (LC) von Ladungsspeichern (C1R, C11, C12), die in Abhängigkeit von einem ersten Steuersignal schaltbar sind, einer zweiten Anordnung (MC) von Ladungsspeichern (C21, C22, ...), die in Abhängigkeit von einem zweiten Steuersignal schaltbar sind, wobei Ladungsspeicher einer Teilgruppe der Ladungsspeicher der zweiten Anordnung (MC) im Wesentlichen gleiche Werte haben und der Digital/Analog-Wandler (DAC) dazu ausgelegt ist, eine Ausgangsspannung in Abhängigkeit von einer Schaltrate der Ladungsspeicher (C1R, C11, C12, ..., C21, C22, ...) der ersten und der zweiten Anordnung (LC, MC) zu erzeugen;
- Vergleichseinrichtungen (CMP), um die Ausgangsspannung mit einer Eingangsspannung zu vergleichen;
- ein Steuerregister (SAR), das einen Datenausgang (DO) umfasst, um einen der Eingangsspannung entsprechenden digitalen Wert in Abhängigkeit von einem Vergleichsergebnis den Vergleichseinrichtungen (CMP) bereitzustellen, wobei das Steuerregister (SAR) dazu ausgelegt ist, ein erstes Steuersignal und ein Zwischensteuersignal gemäß einem sukzessiven Annäherungsprinzip in Abhängigkeit von dem Vergleichsergebnis zu generieren; und
- einen Schaltwählschalter (SCR), der dazu ausgelegt ist, das zweite Steuersignal in Abhängigkeit von dem Zwischensteuersignal so zu generieren, dass auf eine beliebige Weise Segmente mit binär gewichteten Werten mit den Ladungsspeichern der Teilgruppe von Ladungsspeichern gebildet werden, und dass beliebige Kombinationen von Ladungsspeichern der Teilgruppe gebildet werden, wobei jede der Kombinationen demselben durch die zweite Anordnung von Ladungsspeichern darzustellenden Nennwert entspricht.

2. Analog/Digital-Wandler nach Anspruch 1, darüber hinaus Filtereinrichtungen (FIL) umfassend, um den digitalen Wert zu verarbeiten.

3. Analog/Digital-Wandler nach Anspruch 2, wobei die Filtereinrichtungen (FIL) ein Mittelungsfilter umfassen.

4. Analog/Digital-Wandler nach einem der Ansprüche 1 bis 3, wobei die Vergleichseinrichtungen (CMP) im Digital/Analog-Wandler (DAC) enthalten sind.

5. Analog/Digital-Wandler nach einem der Ansprüche 1 bis 4, wobei das erste Steuersignal Bits niedrigerer Wertigkeit des digitalen Werts entspricht, und das zweite Steuersignal und das Zwischensteuersignal Bits höherer Wertigkeit des digitalen Werts entsprechen.

6. Analog/Digital-Wandler nach einem der Ansprüche 1 bis 5, wobei der Schaltwählschalter (SCR) einen Zufallsgenerator (RG) oder eine Nachschlagtabelle (LUT) oder ein Schieberegister zum Bereitstellen mehrerer verschiedener Kombinationen umfasst, um die Segmente auf die beliebige Weise zu bilden.

7. Analog/Digital-Wandler nach einem der Ansprüche 1 bis 6, wobei die Teilgruppe alle Ladungsspeicher der zweiten Anordnung (MC) umfasst.

8. Analog/Digital-Wandler nach einem der Ansprüche 1 bis 6, wobei die zweite Anordnung (MC) die Teilgruppe und einen Ladungsspeicher oder mindestens zwei Ladungsspeicher umfasst, die binär gewichtet sind, und wobei es sich bei den gleichen Werten der Teilgruppe im Wesentlichen um den zweifachen Wert des einen Ladungsspeichers oder den größten Wert der mindestens zwei Ladungsspeicher handelt.

9. Verfahren zur Analog/Digital-Wandlung mit einem Digital/Analog-Wandler (DAC) mit einer ersten Anordnung (LC) von Ladungsspeichern (C1R, C11, C12), die in Abhängigkeit von einem ersten Steuersignal schaltbar sind, einer zweiten Anordnung (MC) von Ladungsspeichern (C21, C22, ...), die in Abhängigkeit von einem zweiten Steuersignal schaltbar sind, wobei Ladungsspeicher einer Teilgruppe der Ladungsspeicher der zweiten Anordnung (MC) im Wesentlichen gleiche Werte haben, wobei das Verfahren iterativ durchgeführt wird und umfasst
- Erzeugen einer Ausgangsspannung in Abhängigkeit von einem Schaltzustand der Ladungsspeicher (C1R, C11, C12, ..., C21, C22, ...) der ersten und zweiten Anordnung (LC, MC);
- Vergleichen der Ausgangsspannung mit einer Eingangsspannung;
- Generieren des ersten Steuersignals und eines Zwischensteuersignals gemäß einem sukzessiven Annäherungsprinzip in Abhängigkeit von dem Vergleichsergebnis;
- Generieren des zweiten Steuersignals in Abhängigkeit von dem Zwischensteuersignal, und zwar so, dass auf beliebige Weise Segmente mit binär gewichteten Werten mit den Ladungsspeichern der Teilgruppe von Ladungsspeichern für verschiedene Iterationen gebildet werden, und dass beliebige Kombinationen von Ladungsspeichern der Teilgruppe gebildet werden, wobei jede der Kombinationen demselben durch die zweite Anordnung von Ladungsspeichern darzustellenden Nennwert entspricht; und
- Bereitstellen eines der Eingangsspannung entsprechenden digitalen Werts in Abhängigkeit von dem Vergleichsergebnis.

10. Verfahren nach Anspruch 9, wobei ein Strom iterativ bereitgestellter digitaler Werte gefiltert wird.

11. Verfahren nach Anspruch 9 oder 10, wobei das erste Steuersignal Bits niedrigerer Wertigkeit des digitalen Werts entspricht, und das zweite Steuersignal und das Zwischensteuersignal Bits höherer Wertigkeit des digitalen Werts entsprechen.

12. Verfahren nach einem der Ansprüche 9 bis 11, wobei mehrere verschiedene Kombinationen durch einen Zufallsgenerator (RG) oder eine Nachschlagtabelle (LUT) oder ein Schieberegister bereitgestellt werden, um die Segmente auf die beliebige Weise zu bilden.

13. Verfahren nach einem der Ansprüche 9 bis 12, wobei die Teilgruppe alle Ladungsspeicher der zweiten Anordnung (MC) umfasst.

14. Verfahren nach einem der Ansprüche 9 bis 12, wobei die zweite Anordnung (MC) die Teilgruppe und einen Ladungsspeicher oder mindestens zwei Ladungsspeicher umfasst, die binär gewichtet sind, und wobei es sich bei den gleichen Werten der Teilgruppe im Wesentlichen um den zweifachen Wert des einen Ladungsspeichers oder den größten Wert der mindestens zwei Ladungsspeicher handelt.

## Revendications

1. Convertisseur analogique-numérique, comprenant
- un convertisseur numérique-analogique (DAC) ayant un premier groupement (LC) de mémoires de charge (C1R, C11, C12) commutables en fonction d'un premier signal de commande, un deuxième groupement (MC) de mémoires de charge (C21, C22, ...) commutables en fonction d'un deuxième signal de commande, où des mémoires de charge d'un sous-ensemble des mémoires de charge du deuxième groupement (MC) ont fondamentalement des valeurs égales et le convertisseur numérique-analogique (DAC) est configuré pour générer une tension de sortie comme fonction d'un état de commutation des mémoires de charge (C1R, C11, C12, ..., C21, C22, ...) du premier et du deuxième groupement (LC, MC) ;
- des moyens de comparaison (CMP) servant à comparer la tension de sortie à une tension d'entrée ;
- un registre de commande (SAR) comprenant une sortie de données (DO) servant à fournir une valeur numérique correspondant à la tension d'entrée comme fonction d'un résultat de comparaison des moyens de comparaison (CMP), le registre de commande (SAR) étant configuré pour générer le premier signal de commande et un signal de commande intermédiaire selon un principe d'approximation successive comme fonction du résultat de comparaison ; et
- un sélecteur de commutation (SCR) configuré pour générer le deuxième signal de commande comme fonction du signal de commande intermédiaire de sorte que des segments ayant des valeurs pondérées de façon binaire sont formés avec les mémoires de charge du sous-ensemble de mémoires de charge d'une manière arbitraire et de sorte que des combinaisons arbitraires de mémoires de charge du sous-ensemble sont formées, où chacune des combinaisons correspond à la même valeur nominale devant être représentée par le deuxième groupement de mémoires de charge.

2. Convertisseur analogique-numérique selon la revendication 1, comprenant en outre des moyens de filtrage (FIL) servant à traiter la valeur numérique.

3. Convertisseur analogique-numérique selon la revendication 2, où les moyens de filtrage (FIL) comprennent un filtre de moyennage.

4. Convertisseur analogique-numérique selon l'une des revendications 1 à 3, où les moyens de comparaison (CMP) sont compris par le convertisseur numérique-analogique (DAC).

5. Convertisseur analogique-numérique selon l'une des revendications 1 à 4, où le premier signal de commande correspond à des bits de moindre importance de la valeur numérique, et le deuxième signal de commande et le signal de commande intermédiaire correspondent à des bits de plus grande importance de la valeur numérique.

6. Convertisseur analogique-numérique selon l'une des revendications 1 à 5, où le sélecteur de commutation (SCR) comprend un générateur aléatoire (RG) ou une table de consultation (LUT) ou un registre de commutation servant à fournir une pluralité de combinaisons différentes pour former les segments de la manière arbitraire.

7. Convertisseur analogique-numérique selon l'une des revendications 1 à 6, où le sous-ensemble comprend toutes les mémoires de charge du deuxième groupement (MC).

8. Convertisseur analogique-numérique selon l'une des revendications 1 à 6, où le deuxième groupement (MC) comprend le sous-ensemble et une mémoire de charge ou au moins deux mémoires de charge pondérées de façon binaire, et où les valeurs égales du sous-ensemble sont fondamentalement de deux fois la valeur de l'une mémoire de charge ou de la plus grande valeur des au moins deux mémoires de charge.

9. Procédé de conversion analogique-numérique comprenant un convertisseur numérique-analogique (DAC) ayant un premier groupement (LC) de mémoires de charge (C1R, C11, C12) commutables en fonction d'un premier signal de commande, un deuxième groupement (MC) de mémoires de charge (C21, C22, ...) commutables en fonction d'un deuxième signal de commande, où des mémoires de charge d'un sous-ensemble des mémoires de charge du deuxième groupement (MC) ont fondamentalement des valeurs égales, le procédé étant réalisé de manière itérative et comprenant
- la génération d'une tension de sortie comme fonction d'un état de commutation des mémoires de charge (C1R, C11, C12, ..., C21, C22, ...) du premier et du deuxième groupement (LC, MC) ;
- la comparaison de la tension de sortie à une tension d'entrée ;
- la génération du premier signal de commande et d'un signal de commande intermédiaire selon un principe d'approximation successive comme fonction du résultat de comparaison ;
- la génération du deuxième signal de commande comme fonction du signal de commande intermédiaire de sorte que des segments ayant des valeurs pondérées de façon binaire sont formés avec les mémoires de charge du sous-ensemble de mémoires de charge d'une manière arbitraire pour différentes itérations et de sorte que des combinaisons arbitraires de mémoires de charge du sous-ensemble sont formées, où chacune des combinaisons correspond à la même valeur nominale devant être représentée par le deuxième groupement de mémoires de charge ; et
- la fourniture d'une valeur numérique correspondant à la tension d'entrée comme fonction du résultat de comparaison.

10. Procédé selon la revendication 9, où un flux de valeurs numériques fournies de manière itérative est filtré.

11. Procédé selon la revendication 9 ou 10, où le premier signal de commande correspond à des bits de moindre importance de la valeur numérique, et le deuxième signal de commande et le signal de commande intermédiaire correspondent à des bits de plus grande importance de la valeur numérique.

12. Procédé selon l'une des revendications 9 à 11, où une pluralité de combinaisons différentes est fournie par un générateur aléatoire (RG) ou par une table de consultation (LUT) ou par un registre de commutation pour former les segments de la manière arbitraire.

13. Procédé selon l'une des revendications 9 à 12, où le sous-ensemble comprend toutes les mémoires de charge du deuxième groupement (MC).

14. Procédé selon l'une des revendications 9 à 12, où le deuxième groupement (MC) comprend le sous-ensemble et une mémoire de charge ou au moins deux mémoires de charge pondérées de façon binaire, et où les valeurs égales du sous-ensemble sont fondamentalement de deux fois la valeur de l'une mémoire de charge ou de la plus grande valeur des au moins deux mémoires de charge.
